(19) Europäisches Patentamt
European Patent Office
Office européen des brevets

(11) **EP 3 633 817 A1**

(12) **EUROPÄISCHE PATENTANMELDUNG**

(43) Veröffentlichungstag:
**08.04.2020 Patentblatt 2020/15**

(51) Int Cl.:
*H02J 3/38* (2006.01)     *G01R 31/42* (2006.01)
*H01H 47/00* (2006.01)     *G01R 31/327* (2006.01)
*G01R 31/04* (2006.01)     *H02M 1/084* (2006.01)

(21) Anmeldenummer: **18198509.4**

(22) Anmeldetag: **03.10.2018**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**KH MA MD TN**

(71) Anmelder: **FRONIUS INTERNATIONAL GmbH**
**4643 Pettenbach (AT)**

(72) Erfinder:
• **WALLISCH, Gerhard**
**1100 Wien (AT)**
• **DANMAYR, Joachim**
**4020 Linz (AT)**

(74) Vertreter: **Sonn & Partner Patentanwälte**
**Riemergasse 14**
**1010 Wien (AT)**

(54) **VERFAHREN ZUR PRÜFUNG EINER TRENNSTELLE EINES PHOTOVOLTAIK-WECHSELRICHTERS UND EIN SOLCHER PHOTOVOLTAIK-WECHSELRICHTER**

(57) Die Erfindung betrifft ein Verfahren zur Prüfung einer Trennstelle (12) eines Photovoltaik-Wechselrichters (1) und einen solchen Photovoltaik-Wechselrichter (1). Erfindungsgemäß wird in einem Prüfmodus zwischen dem Eingang (E_Lx) jeder Leitung (Lx) der Trennstelle (12) und einem Zwischenkreis-Potential (M) jeweils eine Hilfsspannung (U_Lx) eingeprägt, entsprechend einem Schaltmuster abwechselnd jeweils die ersten Schaltkontakte (SW_Lx,1) geschlossen und jeweils die zweiten Schaltkontakte (SW_Lx,2) geöffnet und umgekehrt und werden bei jedem Schaltmuster die Spannungen (U_Lx,GD; U_MN) zwischen dem Ausgang (A_Lx) jeder Leitung (Lx) der Trennstelle (12) und dem Zwischenkreis-Potential (M) gemessen und aus den gemessenen Spannungen (U_Lx,GD; U_MN) die Funktionalität jedes Schaltkontakts (SW_Lx,j) abgeleitet.

FIG. 3

**EP 3 633 817 A1**

**Beschreibung**

Die Erfindung betrifft ein Verfahren zur Prüfung einer Trennstelle eines Photovoltaik-Wechselrichters mit einem Zwischenkreis, wobei die Trennstelle zumindest zwei Leitungen mit jeweils zwei Schaltkontakten in Serie in jeder Leitung aufweist, welche Schaltkontakte zur Prüfung auf Funktionalität entsprechend angesteuert werden.

Die Erfindung betrifft weiters einen Photovoltaik-Wechselrichter zur Umwandlung einer Gleichspannung in eine Wechselspannung zur Einspeisung der Wechselspannung in ein Versorgungsnetz und/oder zur Versorgung von Verbrauchern, mit einem Eingangs-DC-DC-Wandler, einem Zwischenkreis, einem Ausgangs-DC-AC-Wandler und einer Trennstelle mit zumindest zwei Leitungen mit jeweils zwei Schaltkontakten in Serie in jeder Leitung.

Üblicherweise wird als Trennstelle zwischen dem Photovoltaik-Wechselrichter und dem Versorgungsnetz bzw. den Verbrauchern eine Anordnung aus jeweils einem Relaispaar pro Leitung verwendet, um eine sichere Trennung zum Versorgungsnetz bzw. dem Verbraucher zu erreichen. Für die Zulassung zur netzparallelen Einspeisung mit Wechselrichtern ohne galvanische Trennung, ist die Einhaltung einschlägiger Normen und Vorschriften vorausgesetzt. Bspw. ist eine Trennstelle aus zwei voneinander unabhängigen Einrichtungen zur Netzüberwachung mit zugeordneten Schaltern in Serie vorgeschrieben. Die Funktionstüchtigkeit der Schaltstellen ist zu überprüfen, um sicherzustellen, dass vor dem Zuschalten der Relais und vor dem Beginnen eines Einspeisebetriebs ein intakter doppelter Schaltkontaktsatz vorhanden ist und bei Kleben eines einzelnen Schaltkontakts noch alle stromführenden Leiter getrennt werden können.

Die EP 2 837 012 B1 und die AT 513 866 B1 beschreiben Verfahren zur Prüfung einer Trennstelle eines Photovoltaik-Wechselrichters und einem Photovoltaik-Wechselrichter der gegenständlichen Art, wobei die Schaltkontakte entsprechend einem bestimmten Schaltmuster schrittweise geschaltet werden und die Spannungen vor und nach der Trennstelle gemessen und daraus die Funktionalität der Schaltkontakte abgeleitet wird.

Die vorliegende Erfindung ist sowohl bei dreiphasigen Netzen mit drei Phasen und einem Neutralleiter, einphasigen Netzen mit einer Phase und einem Neutralleiter, aber auch dreiphasigen Netzen ohne Neutralleiter oder einphasigen Netzen ohne Neutralleiter wie z.B. dem amerikanischen split-phase-grid oder Einphasendreileiternetz anwendbar.

Die Aufgabe der vorliegenden Erfindung besteht in der Schaffung eines oben genannten Verfahrens zur Prüfung einer Trennstelle eines Photovoltaik-Wechselrichters und eines solchen Photovoltaik-Wechselrichters, welche einfach und kostengünstig und mit möglichst geringem Hardware-Aufwand realisierbar sind. Die Funktionalität der Trennstelle soll möglichst rasch und mit geringem Messaufwand überprüft werden können. Nachteile bekannter Verfahren sollen vermieden oder zumindest reduziert werden.

Gelöst wird die erfindungsgemäße Aufgabe in verfahrensmäßiger Hinsicht dadurch, dass in einem Prüfmodus zwischen dem Eingang jeder Leitung der Trennstelle und einem Zwischenkreis-Potential jeweils eine vom Photovoltaik-Wechselrichter erzeugte Hilfsspannung eingeprägt wird, entsprechend einem Schaltmuster abwechselnd jeweils die ersten Schaltkontakte der Trennstelle geschlossen und jeweils die zweiten Schaltkontakte geöffnet und danach jeweils die zweiten Schaltkontakte geschlossen und jeweils die ersten Schaltkontakte geöffnet werden und bei jedem Schaltmuster der Schaltkontakte die Spannungen zwischen dem Ausgang jeder Leitung der Trennstelle und dem Zwischenkreis-Potential gemessen werden und aus den gemessenen Spannungen bei jedem Schaltmuster der Schaltkontakte die Funktionalität jedes Schaltkontakts abgeleitet wird. Erfindungsgemäß wird die Prüfung der Trennstelle im Prüfmodus unter Heranziehung einer vom Photovoltaik-Wechselrichter, insbesondere dessen Ausgangs-DC-AC-Wandler, erzeugten Hilfsspannung vorgenommen, sodass das Verfahren, im Gegensatz zum Stand der Technik, unabhängig vom Anliegen einer bestimmten Netzspannung ist. Dadurch kann das gegenständliche Prüfverfahren auch bei Inselwechselrichtern und auch bei isolierten Netzen und Stromkreisen, einschließlich von Notstromkreisen, in denen vor Zuschalten des Photovoltaik-Wechselrichters auch keine Spannung anliegt, angewendet werden. Dadurch, dass die Hilfsspannung mit vorhandener Hardware des Photovoltaik-Wechselrichters erzeugt wird, ist der Hardware-Aufwand besonders gering, wodurch das Verfahren sehr einfach und kostengünstig durchgeführt werden kann. Im Wesentlichen ist für die Durchführung des Prüfungsmodus ein bestimmter Ablauf nötig, der softwaremäßig in einer vorhandenen Steuervorrichtung des Photovoltaik-Wechselrichters oder in einer eigenen dafür vorgesehenen Steuervorrichtung (bspw. einem Mikroprozessor) relativ einfach implementiert werden kann. Aus den verschiedenen zum Zwischenkreis-Potential gemessenen Spannungen kann bei jedem Schaltmuster die an jedem Schaltkontakt abfallende Spannung berechnet werden und aus diesen berechneten Spannungen auf die Funktionalität der Schaltkontakte und somit das einwandfreie Funktionieren der Trennstelle rückgeschlossen werden. Bei bisherigen Testverfahren, wurde zum Testen der Schaltkontakte die Netzspannung herangezogen. Nachteilig dabei ist, dass bei funktionierenden Schaltkontakten Taktfilterkondensatoren, die parallel zur eingespeisten Netzspannung angeordnet sind, die Netzspannung in den Zwischenkreis einkoppeln und an die Photovoltaikmodule eine 50Hz Spannung überlagert wird. Dadurch kann ein unzulässig hoher Strom über den Zwischenkreis in die parasitäre Kapazität des Solarmoduls fließen und der Fehlerstromschalter kann ausgelöst werden. Das vorliegende Testverfahren erzeugt hingegen im Wesentlichen keine Ableitströme, welche den Fehlerstromschalter auslösen könnten. Da bei Photovoltaik-Wechselrichter für verschiedene Regelungen ohnedies diverse Spannungen vor und nach der Trennstelle gemessen werden, können diese Einrichtungen auch für die Durchführung des Prüfmodus der Trennstelle verwendet werden. Wichtig ist, dass über die eingespeisten Hilfsspannungen Stromkreise gebildet werden, welche einen Rückschluss auf die an jedem Schaltkontakt anliegende Spannung erlauben, um feststellen zu können, ob ein Schaltkontakt in unerwünschter Weise geschlossen ist bzw. klebt. Als Hilfsspannungen kommen vorzugsweise Kleinspannungen zur Anwendung, worunter üblicherweise Spannungen unter 25 V (AC) verstanden werden.

Vorteilhafterweise werden abwechselnd alle jeweils ersten Schaltkontakte der Trennstelle gleichzeitig geschlossen und alle jeweils zweiten Schaltkontakte geöffnet und danach alle jeweils zweiten Schaltkontakte gleichzeitig geschlossen und alle jeweils ersten Schaltkontakte geöffnet. Durch das gleichzeitige Schließen und Öffnen der jeweils ersten und jeweils zweiten Schaltkontakte aller Leitungen (Phasen und allenfalls Neutralleiter) der Trennstelle kann das Prüfverfahren besonders rasch und einfach mit einem einmaligen Umschaltvorgang durchgeführt werden.

Bei einem Photovoltaik-Wechselrichter für ein dreiphasiges Versorgungsnetz mit drei Phasen und einem Neutralleiter werden drei vom Photovoltaik-Wechselrichter erzeugte Hilfsspannungen zwischen dem Eingang jeder Phase der Trennstelle und dem Zwischenkreis-Potential und über einen Koppelkondensator zumindest eine Hilfsspannung zwischen dem Eingang des Neutralleiters der Trennstelle und dem Zwischenkreis-Potential eingeprägt, und die Spannungen zwischen dem Ausgang jeder Phase und dem Ausgang des Neutralleiters der Trennstelle und die Spannung zwischen dem Ausgang des Neutralleiters der Trennstelle und dem Zwischenkreis-Potential sowie zumindest eine Spannung zwischen dem Eingang einer Phase und dem Eingang des Neutralleiters der Trennstelle gemessen, und es wird aus den gemessenen Spannungen bei jedem Schaltmuster der Schaltkontakte die Funktionalität jedes Schaltkontakts abgeleitet. Dies stellt für ein dreiphasiges Netz mit Neutralleiter eine bevorzugte Methode für die Durchführung des Verfahrens zum Prüfen der Teststelle dar. Im einfachsten Fall werden drei Hilfsspannungen an den Eingang der Trennstelle angelegt, wobei zum Testen der beiden Schaltkontakte im Neutralleiter zumindest eine Hilfsspannung über einen Koppelkondensator in den Neutralleiter eingekoppelt wird. In diesem Fall ist während des Prüfmodus der Eingang des Neutralleiters der Trennstelle nicht mit dem Zwischenkreis-Potential verbunden. Durch das Messen der entsprechenden Spannungen am Ausgang der Trennstelle, an der Trennstelle und zumindest einer Spannung am Eingang der Trennstelle können die Spannungen an allen Schaltkontakten der Trennstelle abgeleitet bzw. berechnet werden und auf die Funktionalität der Schaltkontakte der Trennstelle rückgeschlossen werden.

Bei einem Photovoltaik-Wechselrichter für ein einphasiges Versorgungsnetz mit einer Phase und einem Neutralleiter werden zwei vom Photovoltaik-Wechselrichter erzeugte Hilfsspannungen zwischen dem Eingang der Phase der Trennstelle und dem Zwischenkreis-Potential und zwischen dem Eingang des Neutralleiters der Trennstelle und dem Zwischenkreis-Potential eingeprägt, und die Spannung zwischen dem Ausgang der Phase der Trennstelle und dem Ausgang des Neutralleiters der Trennstelle und die Spannung zwischen dem Ausgang des Neutralleiters der Trennstelle und dem Zwischenkreis-Potential gemessen, und aus den gemessenen Spannungen bei jedem Schaltmuster der Schaltkontakte die Funktionalität jedes Schaltkontakts abgeleitet. Dies stellt eine bevorzugte Ausführungsvariante für ein einphasiges Netz mit Neutralleiter dar, bei dem zwei Hilfsspannungen eingeprägt und lediglich zwei Spannungen an geeigneten Stellen nach der Trennstelle und an der Trennstelle gemessen werden, wodurch auf die Funktionalität aller vier Schaltkontakte der Trennstelle rückgeschlossen werden kann.

Bei einem Photovoltaik-Wechselrichter für ein einphasiges Versorgungsnetz mit zwei Phasen ohne Neutralleiter, einem sogenannten split-phase-grid werden zwei vom Photovoltaik-Wechselrichter erzeugte Hilfsspannungen zwischen dem Eingang jeder Phase der Trennstelle und dem Zwischenkreis-Potential eingeprägt, und die Spannung zwischen den Ausgängen der Phasen der Trennstelle und die Spannung zwischen dem Ausgang einer Phase der Trennstelle und dem Zwischenkreispotential gemessen, und aus den gemessenen Spannungen bei jedem Schaltmuster der Schaltkontakte die Funktionalität jedes Schaltkontakts abgeleitet. Dieses Verfahren ist ähnlich dem oben beschriebenen Prüfverfahren bei einem einphasigen Netz mit Neutralleiter.

Wenn im Prüfmodus die verschiedenen Spannungen gleichzeitig gemessen werden, kann das Verfahren besonders rasch und einfach vorgenommen werden. Natürlich sind in diesem Fall mehrere Einrichtungen zur Messung der Spannungen notwendig, welche jedoch üblicherweise in Photovoltaik-Wechselrichtern ohnedies vorhanden sind. Es ist auch denkbar, mit weniger Einrichtungen zur Messung der Spannungen zwischen den Leitungen (Phasen und dem allfälligen Neutralleiter) die Spannungen, welche für die Ableitung der Funktionalität der Schaltkontakte erforderlich sind, auch hintereinander zu messen.

Die im Prüfmodus gemessenen Spannungen können über mehrere, vorzugsweise 2 bis 20, Perioden gemessen und die Messwerte gemittelt werden. Durch eine Mittelwertbildung mehrerer Messwerte kann das Signal-zu-Rausch-Verhältnis verbessert werden. Die Mittelwertbildung kann unterschiedlich, bspw. durch Bildung eines quadratischen Mittelwerts (RMS, root mean square) erfolgen.

Im Falle der mangelnden Funktionalität eines Schaltkontakts der Trennstelle kann eine Fehlermeldung ausgegeben werden. Die Fehlermeldung kann akustisch, optisch oder auch über ein User Interface fernübertragen werden, um dem Benutzer des Photovoltaik-Wechselrichters in geeigneter Weise rasch einen Fehler der Trennstelle melden zu können.

Gemäß einem weiteren Merkmal der Erfindung ist vorgesehen, dass im Prüfmodus der Strom in jeder Leitung gemessen wird und bei Überschreitung eines vorgegebenen Grenzwerts eine Strombegrenzung aktiviert wird. Durch die Aktivierung einer solchen Strombegrenzung, welche in vielen Photovoltaik-Wechselrichtern ohnedies vorhanden ist, kann verhindert werden, dass bei ungewolltem gleichzeitigen Schließen beider in Serie geschalteten Schaltkontakte einer Phase oder des Neutralleiters, ein zu hoher Strom fließt, der zu Zerstörungen von Schaltungsteilen führen könnte.

Vor der Trennstelle kann ein Netzfilter angeordnet werden. Durch ein solches Netzfilter kann eine Übertragung unzulässiger hoher Frequenzen in das Versorgungsnetz bzw. zu den Verbrauchern verhindert werden.

Gelöst wird die erfindungsgemäße Aufgabe auch durch einen oben genannten Photovoltaik-Wechselrichter, wobei der Ausgangs-DC-AC-Wandler in einem Prüfmodus zur Prüfung der Schaltkontakte der Trennstelle zur Erzeugung von Hilfsspannungen ausgebildet ist, wobei die Hilfsspannungen zwischen dem Eingang jeder Leitung der Trennstelle und einem Zwischenkreis-Potential einprägbar ist, eine Steuervorrichtung derart ausgebildet ist, dass entsprechend einem Schaltmuster abwechselnd jeweils die ersten Schaltkontakte der Trennstelle geschlossen und jeweils die zweiten Schaltkontakte geöffnet und danach jeweils die zweiten Schaltkontakte geschlossen und alle jeweils ersten Schaltkontakte geöffnet werden, und dass Einrichtungen zur Messung der Spannungen zwischen dem Ausgang jeder Leitung der Trennstelle und dem Zwischenkreis-Potential vorgesehen sind und eine Auswerteeinrichtung zur Ableitung der Funktionalität jedes Schaltkontakts aus den gemessenen Spannungen bei jedem Schaltmuster der Schaltkontakte vorgesehen ist. Wie bereits weiter oben erwähnt, zeichnet sich der erfindungsgemäße Photovoltaik-Wechselrichter durch einen besonders geringen Hardware-Aufwand aus. Bezüglich der weiteren dadurch erzielbaren Vorteile wird auf die obige Beschreibung des Prüfverfahrens verwiesen.

Für ein dreiphasiges Versorgungsnetz mit drei Phasen und einem Neutralleiter ist der Ausgangs-DC-AC-Wandler des Photovoltaik-Wechselrichters zur Erzeugung von drei Hilfsspannungen ausgebildet, wobei die Hilfsspannungen zwischen dem Eingang jeder Phase der Trennstelle und dem Zwischenkreis-Potential und über einen Koppelkondensator zumindest eine Hilfsspannung zwischen dem Eingang des Neutralleiters der Trennstelle und dem Zwischenkreis-Potential einprägbar sind, und es sind Einrichtungen zur Messung der Spannungen zwischen dem Ausgang jeder Phase der Trennstelle und eine Einrichtung zur Messung der Spannung zwischen dem Ausgang des Neutralleiters der Trennstelle und dem Zwischenkreis-Potential vorgesehen sowie ist zumindest eine Einrichtung zur Messung der Spannung zwischen dem Eingang einer Phase und dem Eingang des Neutralleiters der Trennstelle vorgesehen, und die Auswerteeinrichtung zur Ableitung der Funktionalität jedes Schaltkontakts aus den gemessenen Spannungen bei jedem Schaltmuster der Schaltkontakte ausgebildet.

Wenn der zumindest eine Koppelkondensator durch den Kondensator eines Netzfilters gebildet ist, kann für die Testvorrichtung vorhandene Hardware eingesetzt werden. Durch ein vor der Trennstelle angeordnetes Netzfilter kann eine Übertragung hochfrequenter Signale verhindert werden und es können EMV (Elektromagnetische Verträglichkeit)-Bestimmungen eingehalten werden.

Für ein einphasiges Versorgungsnetz mit einer Phase und einem Neutralleiter ist der Ausgangs-DC-AC-Wandler zur Erzeugung von zwei Hilfsspannungen ausgebildet, wobei die Hilfsspannungen zwischen dem Eingang der Phase der Trennstelle und zwischen dem Eingang des Neutralleiters der Trennstelle und dem Zwischenkreis-Potential einprägbar sind, und ist eine Einrichtung zur Messung der Spannungen zwischen dem Ausgang der Phase und dem Ausgang des Neutralleiters der Trennstelle und eine Einrichtung zur Messung der Spannung zwischen dem Ausgang des Neutralleiters der Trennstelle und dem Zwischenkreispotential vorgesehen, und ist die Auswerteeinrichtung zur Ableitung der Funktionalität jedes Schaltkontakts aus den gemessenen Spannungen bei jedem Schaltmuster der Schaltkontakte ausgebildet.

Für ein einphasiges Versorgungsnetz mit zwei Phasen ohne Neutralleiter ist der Ausgangs-DC-AC-Wandler zur Erzeugung von zwei Hilfsspannungen ausgebildet, wobei die Hilfsspannungen zwischen den Eingängen der Phasen der Trennstelle und dem Zwischenkreis-Potential einprägbar sind, und ist eine Einrichtung zur Messung der Spannung zwischen den Ausgängen der Phasen der Trennstelle und eine Einrichtung zur Messung der Spannung zwischen dem Ausgang einer Phase der Trennstelle und dem Zwischenkreis-Potential vorgesehen, und ist die Auswerteeinrichtung zur Ableitung der Funktionalität jedes Schaltkontakts aus den gemessenen Spannungen bei jedem Schaltmuster der Schaltkontakte ausgebildet.

Wenn eine Einrichtung zum Zwischenspeichern und zur Mittelwertbildung der gemessenen Spannungen vor und nach der Trennstelle über mehrere, vorzugsweise 2 bis 20, Perioden vorgesehen ist, kann das Signal-zu-Rausch-Verhältnis verbessert werden.

Wenn eine Warneinrichtung zur Ausgabe einer Fehlermeldung im Falle der Erkennung einer mangelnden Funktionalität eines Schaltkontakts der Trennstelle vorgesehen ist, kann der Betreiber des Photovoltaik-Wechselrichters rasch und einfach von einer mangelnden Funktionalität der Trennstelle informiert werden.

Vorzugsweise ist eine Einrichtung zu Begrenzung des Stromes durch jede Phase im Prüfmodus vorgesehen. Dadurch kann, wie bereits oben im Zusammenhang mit dem Prüfverfahren festgehalten, eine Begrenzung des Stromes bei ungewolltem gleichzeitigem Schließen beider in Serie angeordneter Schaltkontakte erreicht werden.

Die jeweils ersten Schaltkontakte aller Leitungen können durch zumindest ein mehrpoliges Relais gebildet sind und die jeweils zweiten Schaltkontakte aller Leitungen durch zumindest ein weiteres mehrpoliges Relais gebildet sein. Die Schaltkontakte können somit durch Doppelrelais oder Mehrfachrelais gebildet werden. Im einfachsten Fall werden sämtlich erste Schaltkontakte durch ein mehrpoliges Relais und sämtliche zweite Schaltkontakte durch ein weiteres mehrpoliges Relais gebildet, wodurch nur zwei Relais für die Realisierung der Trennstelle erforderlich sind.

Die vorliegende Erfindung wird anhand der beigefügten Zeichnungen näher erläutert. Darin zeigen:

Fig. 1 ein schematisches Blockschaltbild eines Photovoltaik-Wechselrichters;

Fig. 2 den Aufbau einer Trennstelle zwischen einem Photovoltaik-Wechselrichter und einem Versorgungsnetz bzw. Verbraucher bei einem dreiphasigen Netz;

Fig. 3 den schematischen Aufbau einer Trennstelle zwischen einem Photovoltaik-Wechselrichter und einem dreiphasigen Ver-sorgungsnetz mit Neutralleiter mit der Anwendung des er-findungsgemäßen Verfahrens zur Überprüfung der Trennstelle;

Fig. 4 den schematischen Aufbau einer Trennstelle zwischen einem Photovoltaik-Wechselrichter und einem einphasigen Versor-gungsnetz mit Neutralleiter mit der Anwendung des erfin-dungsgemäßen Verfahrens zur Überprüfung der Trennstelle; und

Fig. 5 den schematischen Aufbau einer Trennstelle zwischen einem Photovoltaik-Wechselrichter und einem einphasigen Versor-gungsnetz ohne Neutralleiter mit der Anwendung des erfin-dungsgemäßen Verfahrens zur Überprüfung der Trennstelle.

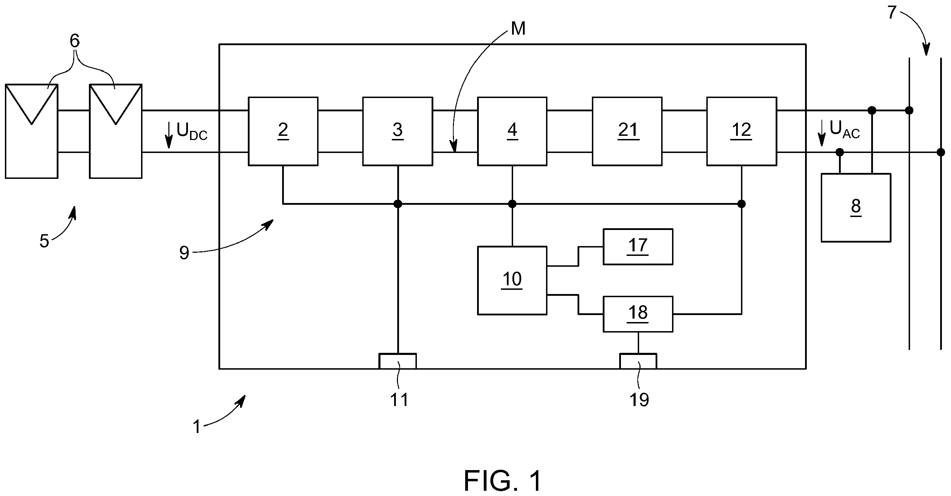

In Fig. 1 ist ein Aufbau eines Photovoltaik-Wechselrichters 1, im Detail eines HF-Wechselrichters, dargestellt. Der Photovoltaik-Wechselrichter 1 weist zumindest einen Eingangs-DC-DC-Wandler 2, einen Zwischenkreis 3 und einen Ausgangs-DC-AC-Wandler 4 auf. Am Eingangs-DC-DC-Wandler 2 ist eine Energiequelle 5 angeschlossen, welche bevorzugt aus einem oder mehreren parallel und/oder seriell zueinander geschalteten Solarmodulen 6 gebildet werden. Der Photovoltaik-Wechselrichter 1 und die Solarmodule 6 werden auch als Photovoltaikanlage bzw. als PV-Anlage bezeichnet. Der Ausgang des Photovoltaik-Wechselrichters 1 bzw. des Ausgangs-DC-AC-Wandlers 4 kann mit einem Versorgungsnetz 7, wie einem öffentlichen oder privaten Wechselspannungsnetz oder einem Mehr-Phasennetz, und/oder mit zumindest einem elektrischen Verbraucher 8, welcher eine Last darstellt, verbunden sein. Beispielsweise wird ein Verbraucher 8 durch einen Motor, Kühlschrank, Funkgerät usw. gebildet. Ebenso kann der Verbraucher 8 auch eine Hausversorgung darstellen.

Bevorzugt dient ein derartiger Photovoltaik-Wechselrichter 1 als sogenannter netzgekoppelter Photovoltaik-Wechselrichter 1, dessen Energiemanagement daraufhin optimiert ist, möglichst viel Energie in das Versorgungsnetz 7 einzuspeisen. Alternativ dazu kann der Photovoltaik-Wechselrichter 1 auch ausschließlich zur Versorgung von Verbrauchern 8 dienen. In diesem Fall spricht man von einem sogenannten Inselwechselrichter.

Die einzelnen Komponenten des Photovoltaik-Wechselrichters 1, wie der Eingangs-DC-DC-Wandler 2 usw., können über einen Datenbus 9 mit einer Steuervorrichtung 10 verbunden sein. Die Steuervorrichtung 10 des Photovoltaik-Wechselrichters 1 ist beispielsweise durch einen Mikroprozessor, Mikrocontroller oder Rechner gebildet. Über die Steuervorrichtung 10 kann eine entsprechende Steuerung der einzelnen Komponenten des Photovoltaik-Wechselrichters 1, wie dem Eingangs-DC-DC-Wandler 2 oder dem Ausgangs-DC-AC-Wandler 4, insbesondere der darin angeordneten Schaltelemente, vorgenommen werden. In der Steuervorrichtung 10 sind hierzu die einzelnen Regel- bzw. Steuerabläufe durch entsprechende Software-Programme und/oder Daten bzw. Kennlinien gespeichert.

Des Weiteren können über den Datenbus 9 mit der Steuervorrichtung 10 Bedienelemente 11 verbunden sein, durch welche der Benutzer beispielsweise den Photovoltaik-Wechselrichter 1 konfigurieren und/oder Betriebszustände oder Parameter anzeigen (beispielsweise mittels Leuchtdioden) und einstellen kann. Die Bedienelemente 11 sind dabei beispielsweise über den Datenbus 9 oder direkt mit der Steuervorrichtung 10 verbunden. Derartige Bedienelemente 11 sind beispielsweise an einer Front des Photovoltaik-Wechselrichters 1 angeordnet, sodass eine Bedienung von außen möglich ist. Ebenso können die Bedienelemente 11 auch direkt an Baugruppen und/oder Modulen innerhalb des Photovoltaik-Wechselrichters 1 angeordnet sein.

Insbesondere bei Verwendung eines Photovoltaik-Wechselrichters 1 zur Einspeisung in ein Versorgungsnetz 7 ist es normativ notwendig, eine Trennstelle 12 zwischen dem Photovoltaik-Wechselrichter 1 und dem Versorgungsnetz 7 zwischenzuschalten. Diese Trennstelle 12 muss vor dem Aufschalten des Photovoltaik-Wechselrichters 1 auf das Versorgungsnetz 7 oder den Verbraucher 8 auf die ordnungsgemäße Funktion überprüft werden. Zu diesem Zweck werden in einem Prüfmodus über eine Steuervorrichtung, welche durch die vorhandene Steuervorrichtung 10 des Photovoltaik-Wechselrichters 1 gebildet sein kann, Hilfsspannungen an die Leitungen der Trennstelle 12 angelegt, die Schaltkontakte der Trennstelle 12 entsprechend einem Schaltmuster betätigt und diverse Spannungen am Ausgang der Trennstelle 12, an der Trennstelle 12 und allenfalls am Eingang der Trennstelle 12 gemessen, aus welchen auf die einzelnen Spannungen an den einzelnen Schaltkontakten der Trennstelle 12 bei jedem Schaltmuster rückgerechnet und dadurch das einwandfreie Funktionieren aller Schaltkontakte festgestellt werden kann. Die Spannungen werden gegenüber einem Zwischenkreis-Potential M des Zwischenkreises 3 gemessen. Zur Messung der Spannungen werden vorzugsweise ohnedies vorhandene Einrichtungen zur Spannungsmessung herangezogen. In einer mit der Steuervorrichtung 10 verbunden Auswerteeinrichtung 17 werden die Spannungen an den einzelnen Schaltkontakten ermittelt und es wird auf die Funktionalität der Schaltkontakte rückgeschlossen. Eine Einrichtung 18 dient dem Zwischenspeichern und allfälligen Mittelwertbildung der gemessenen Spannungen über mehrere Perioden. Über eine Warneinrichtung 19 kann in unterschiedlicher Weise, zum Beispiel akustisch, optisch oder dgl. eine Warnung an einen Benutzer oder Betreiber der Photovoltaikanlage abgegeben werden.

Zwischen dem Ausgangs-DC-AC-Wandler 4 und der Trennstelle 12 kann ein Netzfilter 21 angeordnet sein, welches eine Übertragung unzulässiger hoher Frequenzen über die Ausgangswechselspannung UAC in das Versorgungsnetz 7 bzw. zu den Verbrauchern 8 verhindert.

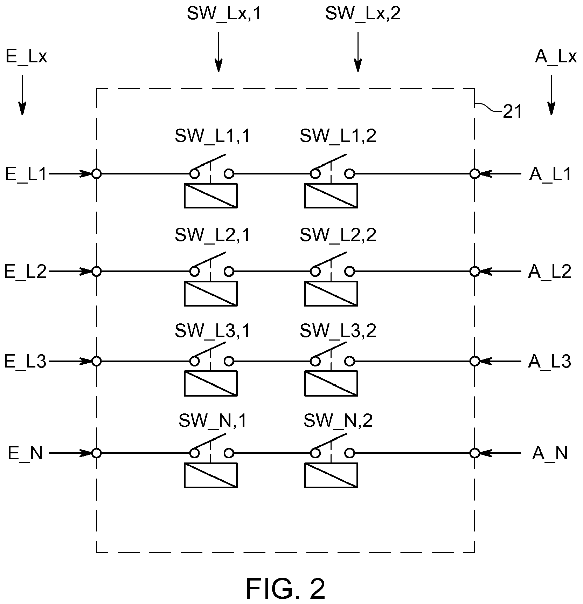

In Fig. 2 ist der Aufbau einer Trennstelle 12 für vier Leitungen Lx, vorzugsweise für ein dreiphasiges Netz mit drei Phasen L1, L2, L3 und einem Neutralleiter N dargestellt. In jeder Leitung Lx befinden sich zwei Schaltkontakte SW_Lx,1 und SW_Lx,2 in Serie. Alle Leitungen Lx der Trennstelle 12 haben Eingänge E_Lx, im dargestellten Beispiel die Eingänge E_Li der Phasen Li und den Eingang E_N des Neutralleiters N sowie Ausgänge A_Lx, hier im Speziellen die Ausgänge A_Li der Phasen Li und den Ausgang A_N des Neutralleiters N. Im Prüfmodus zur Prüfung der Funktion der Schaltkontakte SW_Lx,j werden Hilfsspannungen U_Lx an die Eingänge E_Lx der Trennstelle 12 angelegt und entsprechend einem Schaltmuster abwechselnd jeweils die ersten Schaltkontakte SW_Lx,1 der Trennstelle 12 geschlossen und jeweils die zweiten Schaltkontakte SW_Lx,2 geöffnet und danach jeweils die zweiten Schaltkontakte SW_Lx,2 geschlossen und jeweils die ersten Schaltkontakte SW_Lx,1 geöffnet. Bei jedem Schaltmuster der Schaltkontakte SW_Lx,j werden Spannungen zwischen dem Ausgang A_Lx jeder Leitung Lx der Trennstelle 12 und dem Zwischenkreis-Potential M des Photovoltaik-Wechselrichters 1 gemessen. Aus diesen gemessenen Spannungen bei jedem Schaltmuster der Schaltkontakte SW_Lx,j wird schließlich die Funktionalität jedes Schaltkontakts SW_Lx,j abgeleitet.

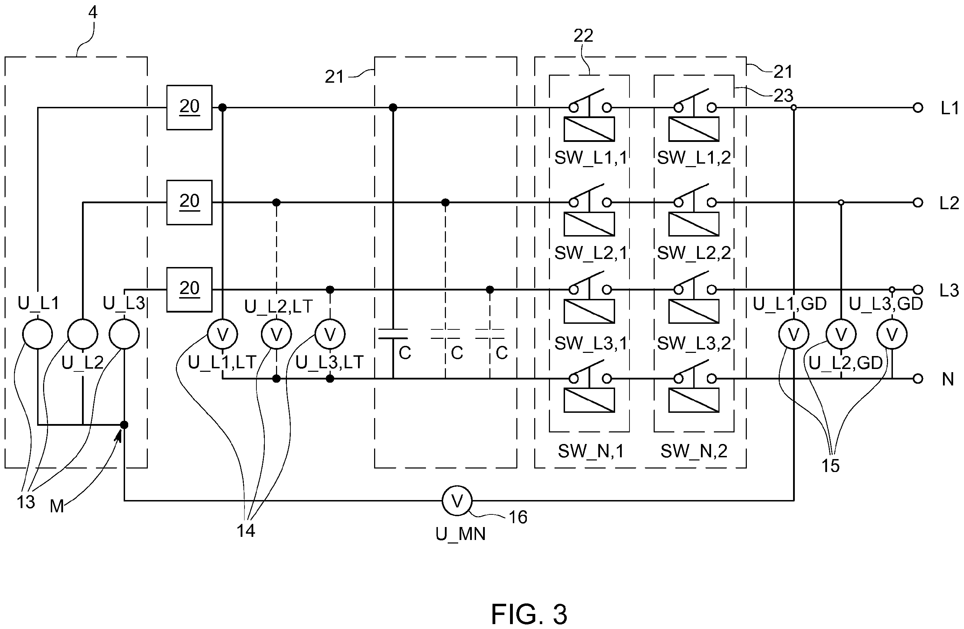

In Fig. 3 ist der Aufbau einer Trennstelle 12 zwischen einem Photovoltaik-Wechselrichter 1 und einem Versorgungsnetz 7 bzw. Verbraucher 8 bei einem dreiphasigen Netz mit drei Phasen L1, L2 und L3 sowie einem Neutralleiter mit der Anwendung des erfindungsgemäßen Verfahrens zur Überprüfung der Trennstelle 12 dargestellt. Erfindungsgemäß werden von entsprechenden Einrichtungen 13 Hilfsspannungen U_Li erzeugt, welche im Prüfmodus zur Prüfung der Schaltkontakte SW_Li,j und SW_N,j zwischen den dem Eingang E_L1, E_L2, E_L3 jeder Phase L1, L2, L3 der Trennstelle 12 und dem Zwischenkreis-Potential M eingeprägt werden. Zur Überprüfung der Schaltkontakte SW_N,1 und SW_N,2 im Neutralleiter N wird eine Hilfsspannung U_L1 über einen Koppelkondensator C zwischen dem Eingang E_N des Neutralleiters N der Trennstelle 12 und dem Zwischenkreis-Potential M eingeprägt. Über Einrichtungen 14 werden die Spannungen U_L1,GD; U_L2,GD; U_L3,GD zwischen dem Ausgang A_L1; A_L2; A_L3 jeder Phase L1; L2; L3 der Trennstelle 12 und dem Ausgang A_N des Neutralleiters N der Trennstelle 12 gemessen. Über eine Einrichtung 16 wird die Spannung U_MN zwischen dem Ausgang A_N des Neutralleiters N der Trennstelle 12 und dem Zwischenkreis-Potential M erfasst. Schließlich ist noch am Eingang der Trennstelle 12 zumindest eine Einrichtung 14 zur Messung der Spannung U_L1,LT zwischen dem Eingang E_L1 der Phase L1 und dem Eingang E_N des Neutralleiters N der Trennstelle 12 vorgesehen. In der Auswerteeinrichtung 17 (siehe Fig. 1) erfolgt die Berechnung der Spannungen an allen Schaltkontakten SW_Li,j und SW_N,j zur Ableitung der Funktionalität jedes Schaltkontakts SW_Li,j und SW_N,j aus den gemessenen Spannungen bei jedem Schaltmuster der Schaltkontakte SW_Li,j und SW_N,j. Entscheidend ist, dass ausreichende Messinformation vorhanden ist, um die über den Schaltkontakten abfallenden Spannungen bestimmen zu können, um auf deren Funktionalität rückschließen zu können. Unter der Voraussetzung des gleichzeitigen Schaltens sämtlicher erster Schaltkontakte SW_Li,1 und SW_N,1 und danach sämtlicher zweiter Schaltkontakte SW_Li,2 und SW_N,2, kann mit einem einmaligen Umschaltvorgang während des Prüfmodus die Prüfung der Trennstelle 12 durchgeführt werden. Wenn die Spannungsdifferenz am Schaltkontakt quasi Null ist, ist dies ein Indiz dafür, dass der Schaltkontakt klebt, also nicht einwandfrei funktioniert. Wenn die Spannungsdifferenz an einem Schaltkontakt im Wesentlichen der eingeprägten Hilfsspannung U_Li, U_N entspricht, funktioniert der entsprechende Schaltkontakt SW_Li,j bzw. SW_N,j.

Die folgende Tabelle zeigt das Schaltmuster für die Prüfung der Schaltkontakte SW_Li,j; SW_N,j der Trennstelle 12 gemäß Fig. 3. Die insgesamt acht Schaltkontakte werden entsprechend einem Schaltmuster, welches zwei Schaltzustände 1 und 2 beinhaltet, aktiviert und bei jedem Schaltzustand 1 bzw. 2 werden die entsprechenden Spannungen gemessen, sodass auf die Differenzspannungen an sämtlichen Schaltkontakten SW_Lx,j rückgerechnet und somit ein Festkleben der Schaltkontakte SW_Lx,j festgestellt werden kann.

| Schaltkontakt | Schaltzustand | |
|---|---|---|
| | 1 | 2 |
| SW_L1,1 | geschlossen | offen |
| SW_L1,2 | offen | geschlossen |
| SW_L2,1 | geschlossen | offen |
| SW_L2,2 | offen | geschlossen |

(fortgesetzt)

| Schaltkontakt | Schaltzustand | |
|---|---|---|
| | 1 | 2 |
| SW_L3,1 | geschlossen | offen |
| SW_L3,2 | offen | geschlossen |
| SW_N,1 | geschlossen | offen |
| SW_N,2 | offen | geschlossen |

Die Berechnung der Spannungen an den einzelnen Schaltkontakten SW_Li,j und SW_N,j erfolgt beispielsweise folgendermaßen:

Für die Messung der Spannungen an den Schaltkontakten SW_Li,j der Phasen Li sind die Spannungen U_Li,LT nicht notwendig.

1.) Berechnung von der Relaispannung der Phase L1:

$$U\_L1 - SW\_L1,1 - SW\_L1,2 - U\_L1,GD + U\_MN = 0 \text{ bzw.}$$
$$SW\_L1,1 + SW\_L1,2 = U\_L1 - U\_L1,GD + U\_MN$$

2.) Berechnung von der Relaisspannung der Phase L2:

$$U\_L2 - SW\_L2,1 - SW\_L2,2 - U\_L2,GD + U\_MN = 0 \text{ bzw.}$$
$$SW\_L2,1 + SW\_L2,2 = U\_L2 - U\_L2,GD + U\_MN$$

3.) Berechnung von der Relaisspannung der Phase L3:

$$U\_L3 - SW\_L3,1 - SW\_L3,2 - U\_L3,GD + U\_MN = 0 \text{ bzw.}$$
$$SW\_L3,1 + SW\_L3,2 = U\_L3 - U\_L3,GD + U\_MN$$

4.) Berechnung von der Relaisspannung des Neutralleiters N (3 Möglichkeiten):

Für die Messung der Spannungen an den Schaltkontakten SW_N,j des Neutralleiters N sind die Spannungen U_Li,GD nach der Trennstelle 12 nicht notwendig.

$$U\_L1 - U\_L1,LT - SW\_N,1 - SW\_N,2 + U\_MN = 0 \text{ bzw.}$$
$$SW\_N,1 + SW\_N,2 = U\_L1 - U\_L1,LT + U\_MN$$

$$U\_L2 - U\_L2,LT - SW\_N,1 - SW\_N,2 + U\_MN = 0 \text{ bzw.}$$
$$SW\_N,1 + SW\_N,2 = U\_L2 - U\_L2,LT + U\_MN$$

$$U\_L3 - U\_L3,LT - SW\_N,1 - SW\_N,2 + U\_MN = 0 \text{ bzw.}$$
$$SW\_N,1 + SW\_N,2 = U\_L3 - U\_L3,LT + U\_MN$$

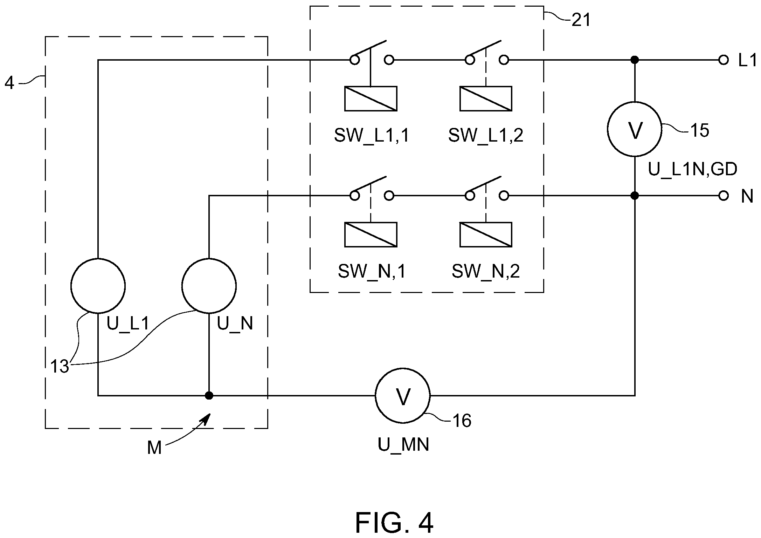

Fig. 4 zeigt den Aufbau einer Trennstelle 12 zwischen einem Photovoltaik-Wechselrichter 1 und einem Versorgungsnetz 7 bzw. Verbraucher 8 bei einem einphasigen Netz mit einer Phase L1 und einem Neutralleiter N mit der Anwendung des erfindungsgemäßen Verfahrens zur Überprüfung der Trennstelle 12. Dabei werden vom Photovoltaik-Wechselrichter 1, insbesondere dem Ausgangs-DC-AC-Wandler 4 zwei Hilfsspannungen U_L1 und U_N erzeugt und zwischen dem Eingang E_L1 der Phase L1 der Trennstelle 12 und zwischen dem Eingang E_N des Neutralleiters N der Trennstelle 12 und dem Zwischenkreis-Potential M eingeprägt. Mit Hilfe einer Einrichtung 14 wird die Spannung U_L1N,GD zwischen dem Ausgang A_L1 der Phase L1 und dem Ausgang A_N des Neutralleiters N der Trennstelle 12 gemessen. Mit der Einrichtung 16 wird die Spannung U_MN zwischen dem Ausgang A_N des Neutralleiters N der Trennstelle 12 und dem Zwischenkreis-Potential M erfasst. Über die Auswerteeinrichtung 17 erfolgt die Berechnung der Differenzspannungen an den Schaltkontakten SW_L1,j und SW_N,j, woraus deren Funktionalität abgeleitet werden kann. Das Schaltmuster sieht in diesem Fall vorzugsweise folgendermaßen aus:

| Schaltkontakt | Schaltzustand | |
|---|---|---|
| | 1 | 2 |
| SW_L1,1 | geschlossen | offen |
| SW_L1,2 | offen | geschlossen |
| SW_N,1 | geschlossen | offen |
| SW_N,2 | offen | geschlossen |

1.) Berechnung der Relaisspannung an Phase L1:

$$U\_L1 - SW\_L1,1 - SW\_L1,2 + U\_L1N,GD - U\_MN = 0 \text{ bzw.}$$
$$SW\_L1,1 + SW\_L1,2 = U\_L1 + U\_L1N,GD - U\_MN$$

2.) Berechnung der Relaisspannung am Neutralleiter N:
Hierfür wird U_L1N,GD nicht benötigt

$$U\_N - SW\_N,1 - SW\_N,2 - U\_MN = 0 \text{ bzw.}$$
$$SW\_N,1 + SW\_N,2 = U\_N - U\_MN$$

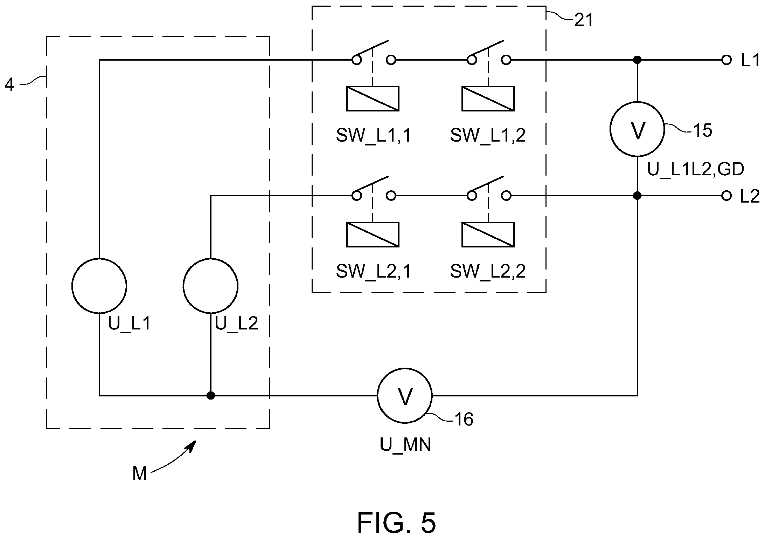

Fig. 5 zeigt den Aufbau einer Trennstelle 12 zwischen einem Photovoltaik-Wechselrichter 1 und einem Versorgungsnetz 7 bzw. Verbraucher 8 bei einem einphasigen Netz mit zwei Phasen L1 und L2 ohne Neutralleiter N mit der Anwendung des erfindungsgemäßen Verfahrens zur Überprüfung der Trennstelle 12. Dabei werden vom Photovoltaik-Wechselrichter 1, insbesondere dem Ausgangs-DC-AC-Wandler 4 zwei Hilfsspannungen U_L1 und U_L2 erzeugt und zwischen den Eingängen E_L1 und E_L2 der Phasen L1 und L2 der Trennstelle 12 und dem Zwischenkreis-Potential M eingeprägt. Mit Hilfe einer Einrichtung 14 wird die Spannung U_L1L2,GD zwischen dem Ausgang A_L1 der Phase L1 und dem Ausgang A_L2 der Phase L2-der Trennstelle 12 gemessen. Mit der Einrichtung 16 wird die Spannung U_MN zwischen dem Ausgang A_L2 der Phase L2 der Trennstelle 12 und dem Zwischenkreis-Potential M erfasst. Über die Auswerteeinrichtung 17 erfolgt die Berechnung der Differenzspannungen an den Schaltkontakten SW_L1,j und SW_L2,j, woraus deren Funktionalität abgeleitet werden kann. Das Schaltmuster sieht in diesem Fall vorzugsweise folgendermaßen aus:

| Schaltkontakt | Schaltzustand | |
|---|---|---|
| | 1 | 2 |
| SW_L1,1 | geschlossen | offen |
| SW_L1,2 | offen | geschlossen |
| SW_L2,1 | geschlossen | offen |
| SW_L2,2 | offen | geschlossen |

1.) Berechnung der Relaisspannung an Phase L1:

$$U\_L1 - SW\_L1,1 - SW\_L1,2 + U\_L1L2,GD - U\_MN = 0 \text{ bzw.}$$
$$SW\_L1,1 + SW\_L1,2 = U\_L1 + U\_L1L2,GD - U\_MN$$

2.) Berechnung der Relaisspannung an Phase L2:
Hierfür wird U_L1L2,GD nicht benötigt.

$$U\_L2 - SW\_L2{,}1 - SW\_L2{,}2 - U\_MN = 0 \text{ bzw.}$$
$$SW\_L2{,}1 + SW\_L2{,}2 = U\_L2 - U\_MN$$

Natürlich sind andere Anordnungen der Spannungsmesseinrichtungen auch denkbar, wobei darauf geachtet werden muss, dass immer entsprechend viele Spannungen gemessen werden, dass eindeutig auf die Spannungen an den einzelnen Schaltkontakten der Trennstelle 12 rückgerechnet werden kann.

**Patentansprüche**

1. Verfahren zur Prüfung einer Trennstelle (12) eines Photovoltaik-Wechselrichters (1) mit einem Zwischenkreis (3), wobei die Trennstelle (12) zumindest zwei Leitungen (Lx) mit jeweils zwei Schaltkontakten (SW_Lx,j) in Serie in jeder Leitung (Lx) aufweist, welche Schaltkontakte (SW_Lx,j) zur Prüfung auf Funktionalität entsprechend angesteuert werden, **dadurch gekennzeichnet, dass** in einem Prüfmodus zwischen dem Eingang (E_Lx) jeder Leitung (Lx) der Trennstelle (12) und einem Zwischenkreis-Potential (M) jeweils eine vom Photovoltaik-Wechselrichter (1) erzeugte Hilfsspannung (U_Lx) eingeprägt wird, entsprechend einem Schaltmuster abwechselnd jeweils die ersten Schaltkontakte (SW_Lx,1) der Trennstelle (12) geschlossen und jeweils die zweiten Schaltkontakte (SW_Lx,2) geöffnet und danach jeweils die zweiten Schaltkontakte (SW_Lx,2) geschlossen und jeweils die ersten Schaltkontakte (SW_Lx,1) geöffnet werden und bei jedem Schaltmuster der Schaltkontakte (SW_Lx,j) die Spannungen (U_Lx,GD; U_MN) zwischen dem Ausgang (A_Lx) jeder Leitung (Lx) der Trennstelle (12) und dem Zwischenkreis-Potential (M) gemessen werden und aus den gemessenen Spannungen (U_Lx,GD; U_MN) bei jedem Schaltmuster der Schaltkontakte (SW_Lx,j) die Funktionalität jedes Schaltkontakts (SW_Lx,j) abgeleitet wird.

2. Verfahren nach Anspruch 1, **dadurch gekennzeichnet, dass** abwechselnd alle jeweils ersten Schaltkontakte (SW_Lx,1) der Trennstelle (12) gleichzeitig geschlossen und alle jeweils zweiten Schaltkontakte (SW_Lx,2) geöffnet und danach alle jeweils zweiten Schaltkontakte (SW_Lx,2) gleichzeitig geschlossen und alle jeweils ersten Schaltkontakte (SW_Lx,1) geöffnet werden.

3. Verfahren nach Anspruch 1 oder 2, **dadurch gekennzeichnet, dass** bei einem Photovoltaik-Wechselrichter (1) für ein dreiphasiges Versorgungsnetz (7) mit drei Phasen (L1, L2, L3) und einem Neutralleiter (N) drei vom Photovoltaik-Wechselrichter (1) erzeugte Hilfsspannungen (U_L1, U_L2, U_L3) zwischen dem Eingang (E_L1, E_L2, E_L3) jeder Phase (L1, L2, L3) der Trennstelle (12) und dem Zwischenkreis-Potential (M) und über einen Koppelkondensator (C) zumindest eine Hilfsspannung (U_L1) zwischen dem Eingang (E_N) des Neutralleiters (N) der Trennstelle (12) und dem Zwischenkreis-Potential (M) eingeprägt wird, und die Spannungen (U_L1,GD, U_L2,GD, U_L3,GD) zwischen dem Ausgang (A_L1, A_L2, A_L3) jeder Phase (L1, L2, L3) und dem Ausgang (A_N) des Neutralleiters (N) der Trennstelle (12) und die Spannung (U-MN) zwischen dem Ausgang (A_N) des Neutralleiters (N) der Trennstelle (12) und dem Zwischenkreis-Potential (M) sowie zumindest eine Spannung (U_Li,LT) zwischen dem Eingang (E_Li) einer Phase (Li) und dem Eingang (E_N) des Neutralleiters (N) der Trennstelle (12) gemessen werden, und aus den gemessenen Spannungen (U_L1,GD, U_L2,GD, U_L3,GD, U_MN, U_Li,LT) bei jedem Schaltmuster der Schaltkontakte (SW_Li,j; SW_N,j) die Funktionalität jedes Schaltkontakts (SW_Li,j; SW_N,j) abgeleitet wird.

4. Verfahren nach Anspruch 1 oder 2, **dadurch gekennzeichnet, dass** bei einem Photovoltaik-Wechselrichter (1) für ein einphasiges Versorgungsnetz (7) mit einer Phase (L1) und einem Neutralleiter (N) zwei vom Photovoltaik-Wechselrichter (1) erzeugte Hilfsspannungen (U_L1, U_N) zwischen dem Eingang (E_L1) der Phase (L1) der Trennstelle (12) und dem Zwischenkreis-Potential (M) und zwischen dem Eingang (E_N) des Neutralleiters (N) der Trennstelle (12) und dem Zwischenkreis-Potential (M) eingeprägt wird, und die Spannung (U_L1N,GD) zwischen dem Ausgang (A_L1) der Phase (L1) der Trennstelle (12) und dem Ausgang (A_N) des Neutralleiters (N) der Trennstelle (12) und die Spannung (U-MN) zwischen dem Ausgang (A_N) des Neutralleiters (N) der Trennstelle (12) und dem Zwischenkreis-Potential (M) gemessen werden, und aus den gemessenen Spannungen (U_L1N,GD; U_MN) bei jedem Schaltmuster der Schaltkontakte (SW_Li,j; SW_N,j) die Funktionalität jedes Schaltkontakts (SW_Li,j;SW_N,j) abgeleitet wird.

5. Verfahren nach Anspruch 1 oder 2, **dadurch gekennzeichnet, dass** bei einem Photovoltaik-Wechselrichter (1) für ein einphasiges Versorgungsnetz (7) mit zwei Phasen (L1, L2) zwei vom Photovoltaik-Wechselrichter (1) erzeugte Hilfsspannungen (U_L1, U L2) zwischen dem Eingang (E_L1, E_L2) jeder Phase (L1, L2) der Trennstelle (12) und dem Zwischenkreis-Potential (M) eingeprägt wird, und die Spannung (U_L1L2,GD) zwischen den Ausgängen (A_L1, A_L2) der Phasen (L1, L2) der Trennstelle (12) und die Spannung (U-MN) zwischen dem Ausgang (A_L2) einer Phase (L2) der Trennstelle (12) und dem Zwischenkreispotential (M) gemessen werden, und aus den gemessenen Spannungen (U_L1L2,GD; U MN) bei jedem Schaltmuster der Schaltkontakte (SW_Li,j) die Funktionalität jedes Schaltkontakts (SW_Li,j) abgeleitet wird.

6. Verfahren nach einem der Ansprüche 1 bis 5, **dadurch gekennzeichnet, dass** die im Prüfmodus gemessenen Spannungen (U_Lx,LT; U_Lx,GD; U_MN) über mehrere, vorzugsweise 2 bis 20, Perioden gemessen und die Messwerte gemittelt werden.

7. Verfahren nach einem der Ansprüche 1 bis 6, **dadurch gekennzeichnet, dass** im Prüfmodus der Strom (I Lx) in jeder Leitung (Lx) gemessen wird und bei Überschreitung eines vorgegebenen Grenzwerts (I_Lx,g) eine Strombegrenzung aktiviert wird.

8. Photovoltaik-Wechselrichter (1) zur Umwandlung einer Gleichspannung (UDC) in eine Wechselspannung (UAC) zur Einspeisung der Wechselspannung (UAC) in ein Versorgungsnetz (7) und/oder zur Versorgung von Verbrauchern (8), mit einem Eingangs-DC-DC-Wandler (2), einem Zwischenkreis (3), einem Ausgangs-DC-AC-Wandler (4) und einer Trennstelle (12) mit zumindest zwei Leitungen (Lx) mit jeweils zwei Schaltkontakten (SW_Lx,j) in Serie in jeder Leitung (Lx), **dadurch gekennzeichnet, dass** der Ausgangs-DC-AC-Wandler (4) in einem Prüfmodus zur Prüfung der Schaltkontakte (SW_Lx,j) der Trennstelle (12) zur Erzeugung von Hilfsspannungen (U_Lx) ausgebildet ist, wobei die Hilfsspannungen (U_Lx) zwischen dem Eingang (E_Lx) jeder Leitung (Lx) der Trennstelle (12) und einem Zwischenkreis-Potential (M) einprägbar ist, eine Steuervorrichtung (10) derart ausgebildet ist, dass entsprechend einem Schaltmuster abwechselnd jeweils die ersten Schaltkontakte (SW_Lx,1) der Trennstelle (12) geschlossen und jeweils die zweiten Schaltkontakte (SW_Lx,2) geöffnet und danach jeweils die zweiten Schaltkontakte (SW_Lx,2) geschlossen und alle jeweils ersten Schaltkontakte (SW_Lx,1) geöffnet werden, und dass Einrichtungen (14) zur Messung der Spannungen (U_Lx,GD; U MN) zwischen dem Ausgang (A_Lx) jeder Leitung (Lx) der Trennstelle (12) und dem Zwischenkreis-Potential (M) vorgesehen sind und eine Auswerteeinrichtung (17) zur Ableitung der Funktionalität jedes Schaltkontakts (SW_Lx,j) aus den gemessenen Spannungen (U_Lx,LT; U_Lx,GD; U_MN) bei jedem Schaltmuster der Schaltkontakte (SW_Lx,j) vorgesehen ist.

9. Photovoltaik-Wechselrichter (1) nach Anspruch 8, **dadurch gekennzeichnet, dass** für ein dreiphasiges Versorgungsnetz (7) mit drei Phasen (L1, L2, L3) und einem Neutralleiter (N) der Ausgangs-DC-AC-Wandler (4) zur Erzeugung von drei Hilfsspannungen (U_L1, U_L2, U_L3) ausgebildet ist, wobei die Hilfsspannungen (U_Li) zwischen dem Eingang (E_L1; E_L2;E_L3) jeder Phase (L1; L2; L3) der Trennstelle (12) und dem Zwischenkreis-Potential (M) und über einen Koppelkondensator (C) zumindest eine Hilfsspannung (U_L1) zwischen dem Eingang (E N) des Neutralleiters (N) der Trennstelle (12) und dem Zwischenkreis-Potential (M) einprägbar sind, und dass Einrichtungen (14) zur Messung der Spannungen (U_L1,GD; U_L2,GD; U_L3,GD) zwischen dem Ausgang (A_L1; A_L2; A_L3) jeder Phase (L1; L2; L3) der Trennstelle (12) und dem Ausgang (A_N) des Neutralleiters (N) der Trennstelle (12) eine Einrichtung (16) zur Messung der Spannung (U-MN) zwischen dem Ausgang (A_N) des Neutralleiters (N) der Trennstelle (12) und dem Zwischenkreis-Potential (M) sowie zumindest eine Einrichtung (14) zur Messung der Spannung (U_Li,LT) zwischen dem Eingang (E_Li) einer Phase (Li) und dem Eingang (E N) des Neutralleiters (N) der Trennstelle (12) vorgesehen ist, und dass die Auswerteeinrichtung (17) zur Ableitung der Funktionalität jedes Schaltkontakts (SW_Li,j; SW_N,j) aus den gemessenen Spannungen (U_L1,GD; U_L2,GD; U_L3,GD; U_MN; U_L1,LT) bei jedem Schaltmuster der Schaltkontakte (SW_Li,j; SW_N,j) ausgebildet ist.

10. Photovolatik-Wechselrichter (1) nach Anspruch 9, **dadurch gekennzeichnet, dass** der zumindest eine Koppelkondensator (C) durch den Kondensator (C) eines Netzfilters (21) gebildet ist.

11. Photovoltaik-Wechselrichter (1) nach Anspruch 8, **dadurch gekennzeichnet, dass** für ein einphasiges Versorgungsnetz (7) mit einer Phase (L1) und einem Neutralleiter (N) der Ausgangs-DC-AC-Wandler (4) zur Erzeugung von zwei Hilfsspannungen (U_L1, U_N) ausgebildet ist, wobei die Hilfsspannungen (U_L1, U_N) zwischen dem Eingang (E_L1) der Phase (L1) der Trennstelle (12) und zwischen dem Eingang (E_N) des Neutralleiters (N) der Trennstelle (12) und dem Zwischenkreis-Potential (M) einprägbar sind, und dass eine Einrichtung (14) zur Messung der Spannungen (U_L1N,GD) zwischen dem Ausgang (A_L1) der Phase (L1) und dem Ausgang (A_N) des Neutralleiters (N) der Trennstelle (12) und eine Einrichtung (16) zur Messung der Spannung (U_MN) zwischen dem Ausgang (A_N) des Neutralleiters (N) der Trennstelle (12) und dem Zwischenkreispotential (M) vorgesehen ist, und dass die Auswerteeinrichtung (17) zur Ableitung der Funktionalität jedes Schaltkontakts (SW_Li,j; SW_N,j) aus den gemessenen Spannungen (U_L1N,GD; U_MN) bei jedem Schaltmuster der Schaltkontakte (SW_Li,j; SW_N,j) ausgebildet ist.

**12.** Photovoltaik-Wechselrichter (1) nach Anspruch 8, **dadurch gekennzeichnet, dass** für ein einphasiges Versorgungsnetz (7) mit zwei Phasen (L1, L2) der Ausgangs-DC-AC-Wandler (4) zur Erzeugung von zwei Hilfsspannungen (U_L1, U_L2) ausgebildet ist, wobei die Hilfsspannungen (U_L1, U_L2) zwischen den Eingängen (E_L1, E_L2) der Phasen (L1, L2) der Trennstelle (12) und dem Zwischenkreis-Potential (M) einprägbar sind, und dass eine Einrichtung (15) zur Messung der Spannung (U_L1L2,GD) zwischen den Ausgängen (A_L1, A_L2) der Phasen (L1, L2) der Trennstelle (12) und eine Einrichtung (16) zur Messung der Spannung (U-MN) zwischen dem Ausgang (A_L2) einer Phase (L2) der Trennstelle (12) und dem Zwischenkreis-Potential (M) vorgesehen ist, und dass die Auswerteeinrichtung (17) zur Ableitung der Funktionalität jedes Schaltkontakts (SW_Li,j; SW_N,j) aus den gemessenen Spannungen (U_L1L2,GD; U_MN) bei jedem Schaltmuster der Schaltkontakte (SW_Li,j; SW_N,j) ausgebildet ist.

**13.** Photovoltaik-Wechselrichter (1) nach einem der Ansprüche 8 bis 12, **dadurch gekennzeichnet, dass** eine Warneinrichtung (19) zur Ausgabe einer Fehlermeldung im Falle der Erkennung einer mangelnden Funktionalität eines Schaltkontakts (SW_Lx,j) der Trennstelle (12) vorgesehen ist.

**14.** Photovoltaik-Wechselrichter (1) nach einem der Ansprüche 8 bis 13, **dadurch gekennzeichnet, dass** eine Einrichtung (20) zur Begrenzung des Stromes (I_Lx) durch jede Leitung (Lx) im Prüfmodus vorgesehen ist.

**15.** Photovoltaik-Wechselrichter (1) nach einem der Ansprüche 8 bis 14, **dadurch gekennzeichnet, dass** die jeweils ersten Schaltkontakte (SW_Lx,1) aller Leitungen (Lx) der Trennstelle (12) durch zumindest ein mehrpoliges Relais (22) gebildet sind und die jeweils zweiten Schaltkontakte (SW_Lx,2) aller Leitungen (Lx) der Trennstelle (12) durch zumindest ein weiteres mehrpoliges Relais (23) gebildet sind.

FIG. 1

EP 3 633 817 A1

FIG. 2

FIG. 3

EP 3 633 817 A1

FIG. 4

FIG. 5

EP 3 633 817 A1

Europäisches
Patentamt

European
Patent Office

Office européen
des brevets

**EUROPÄISCHER RECHERCHENBERICHT**

Nummer der Anmeldung

EP 18 19 8509

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| A | EP 2 608 375 A2 (KOSTAL IND ELEKTRIK GMBH [DE]) 26. Juni 2013 (2013-06-26) * Absatz [0001] - Absatz [0040]; Abbildungen 1-5 * | 1-15 | INV. H02J3/38 G01R31/42 H01H47/00 G01R31/327 |
| A | US 2011/298470 A1 (GOKHALE KALYAN P [US] ET AL) 8. Dezember 2011 (2011-12-08) * Absatz [0004] - Absatz [0028]; Abbildungen 1-5 * | 1-15 | G01R31/04 H02M1/084 |
| A | US 2016/268923 A1 (BREMICKER SVEN [DE]) 15. September 2016 (2016-09-15) * Absatz [0003] - Absatz [0035]; Abbildung 1 * | 1-15 | |
| A | US 2014/226365 A1 (OBERZAUCHER FRIEDRICH [AT] ET AL) 14. August 2014 (2014-08-14) * Absatz [0001] - Absatz [0053]; Abbildungen 1-2 * | 1-15 | |
| A | JP 2004 187362 A (MATSUSHITA ELECTRIC WORKS LTD) 2. Juli 2004 (2004-07-02) * das ganze Dokument * | 1-15 | **RECHERCHIERTE SACHGEBIETE (IPC)** H02J G01R |
| A | US 2016/099569 A1 (RILLING SEBASTIAN [DE] ET AL) 7. April 2016 (2016-04-07) * Absatz [0001] - Absatz [0094]; Abbildungen 1-5 * | 1-15 | H01H H02M |

Der vorliegende Recherchenbericht wurde für alle Patentansprüche erstellt

| Recherchenort | Abschlußdatum der Recherche | Prüfer |
|---|---|---|
| München | 13. März 2019 | Holz, Matthias |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes
    Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 18 19 8509

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

13-03-2019

| Im Recherchenbericht angeführtes Patentdokument | Datum der Veröffentlichung | Mitglied(er) der Patentfamilie | Datum der Veröffentlichung |
|---|---|---|---|
| EP 2608375 A2 | 26-06-2013 | DE 102011122359 A1<br>EP 2608375 A2 | 27-06-2013<br>26-06-2013 |
| US 2011298470 A1 | 08-12-2011 | CN 103503290 A<br>EP 2671315 A2<br>US 2011298470 A1<br>WO 2011153427 A2 | 08-01-2014<br>11-12-2013<br>08-12-2011<br>08-12-2011 |
| US 2016268923 A1 | 15-09-2016 | CN 105765819 A<br>DE 102013113000 A1<br>EP 3075056 A1<br>JP 6472799 B2<br>JP 2016537954 A<br>US 2016268923 A1<br>WO 2015074965 A1 | 13-07-2016<br>28-05-2015<br>05-10-2016<br>20-02-2019<br>01-12-2016<br>15-09-2016<br>28-05-2015 |
| US 2014226365 A1 | 14-08-2014 | AT 513866 A1<br>CN 103997056 A<br>DE 102014202426 A1<br>US 2014226365 A1 | 15-08-2014<br>20-08-2014<br>14-08-2014<br>14-08-2014 |
| JP 2004187362 A | 02-07-2004 | JP 3979278 B2<br>JP 2004187362 A | 19-09-2007<br>02-07-2004 |
| US 2016099569 A1 | 07-04-2016 | DE 102013104629 A1<br>EP 2994767 A1<br>US 2016099569 A1<br>WO 2014180757 A1 | 06-11-2014<br>16-03-2016<br>07-04-2016<br>13-11-2014 |

EPO FORM P0461

Für nähere Einzelheiten zu diesem Anhang : siehe Amtsblatt des Europäischen Patentamts, Nr.12/82

**EP 3 633 817 A1**